Europäisches Patentamt

European Patent Office

Office européen des brevets

(19)

(11) Veröffentlichungsnummer: **0 004 337**
**B1**

(12) **EUROPÄISCHE PATENTSCHRIFT**

(45) Veröffentlichungstag der Patentschrift: **11.11.81**

(51) Int. Cl.³: **G 03 D 3/13, G 03 F 7/02**

(21) Anmeldenummer: **79100771.9**

(22) Anmeldetag: **15.03.79**

(54) Einrichtung zum Entwickeln von Druckplatten mit paarweise horizontal angeordneten oberen und unteren Walzen.

(30) Priorität: **23.03.78 DE 2812688**

(43) Veröffentlichungstag der Anmeldung:
**03.10.79 Patentblatt 79/20**

(45) Bekanntmachung des Hinweises auf die Patenterteilung:
**11.11.81 Patentblatt 81/45**

(84) Benannte Vertragsstaaten:
**BE DE FR GB IT NL SE**

(56) Entgegenhaltungen:
**DE - A - 2 326 122**
**DE - B - 1 240 530**
**DE - C - 912 816**
**GB - A - 408 441**
**GB - A - 620 148**

(73) Patentinhaber: **HOECHST AKTIENGESELLSCHAFT**
**Postfach 80 03 20**
**D-6230 Frankfurt/Main 80 (DE)**

(72) Erfinder: **Diels, Wolfgang**
**Radweg 20**
**D-6500 Mainz-Weisenau (DE)**
Erfinder: **Krause, Dieter**
**Alemannenstrasse 12**
**D-6200 Wiesbaden (DE)**
Erfinder: **Töpfer, Dieter**
**Mühlweg 5**
**D-6209 Heidenrod 3 (DE)**

Courier Press, Leamington Spa, England.

Einrichtung zum Entwickeln von Druckplatten mit paarweise horizontal angeordneten oberen und unteren Walzen

Die Erfindung betrifft eine Einrichtung zum Entwickeln von Druckplatten mit paarweise horizontal angeordneten oberen und unteren Walzen zum Transport der Druckplatten und gegebenenfalls zum Abquetschen von an den Druckplatten haftender Restflüssigkeit, mit je einem, an jedem Ende jeder oberen Walze bezüglich der unteren Walze anhebbar und absenkbar angeordneten Lager, das über eine Kniehebelanordnung betätigbar ist.

Bei einer derartigen bekannten Einrichtung (DE—A—23 26 122) ragen die obere und die untere Walze eines Walzenpaars mit ihren Wellenzapfen auf jeder Seite in ein Gehäuse hinein. In diesem ist das untere Lager fest angeordnet, während das obere Lager um einer zur Lagerachse exzentrischen Zapfen schwenkbar ist. An seiner dem Zapfen gegenüberliegenden Seite ist das Lager mit einem Gelenk verbunden. Das Gelenk ist an ein unteres Ende eines Hebels angelenkt, der um einen waagerechten Zapfen schwenkbar ist. Dieser Zapfen ist in einer an der oberen Wandung des Gehäuses befestigten Konsole angeordnet. Auf der Oberseite des Gehäuses ragt ein Betätigungsgriff heraus, der mit dem schwenkbaren Hebel verbunden ist. Dieser Hebel und das Gelenk bilden eine Kniehebelanordnung, die in ihrer gestreckten Position die obere Walze gegen die untere walze drückt und durch Umlegen des Betätigungsgriffes die obere Walze von der unteren abhebt. Mit einer Entlastungsfeder ist dafür gesorgt, daß die obere Walze in ihrer abgehobenen Lage festgehalten wird.

Bei dieser Einrichtung ist nachteilig, daß zum Abheben der oberen Walzen, das vor längeren Stillstandzeiten, z.B. über Nacht oder über ein Wochenende erfolgen muß, eine Vielzahl von Betätigungsgriffen zu bedienen ist, da jedem Ende jeder oberen Walze ein separater Betätigungsgriff zugeordnet ist. Diese Bedienung ist umständlich und zeitraubend, so daß die Versuchung besteht, diese Bedienung gelegentlich zu unterlassen. Verbleiben jedoch die Walzen der Walzenpaare über längere Stillstandzeiten, z.b. über Nacht oder über ein Wochenende aneinandergepreßt, so können Deformierungen ihrer Oberflächen eintreten, welche einen sicheren und schonenden Transport der Druckplatten sowie eine einwandfreie Flüssigkeitsabquetschung vor allem bei waagerechten Verarbeitungsanlagen gefährden können.

Zum Stand der Technik gehört ebenfalls eine Einrichtung zum Entwickeln von Druckplatten mit paarweise angeordneten Rollen, deren Enden in Seitenschildern gelagert sind. Diese Seitenschilder sind so aufgeteilt und mittels einem dem oberen Seitenschild zugeordneten Drehpunkt und entsprechenden Hubelementen derart ausgerüstet, daß der komplette obere Teil der Seitenschilder bzw. der Verarbeitungszone einschließlich aller oberen Walzen angehoben werden kann.

Diese Einrichtung ist verhältnismäßig aufwendig, insbesondere dann, wenn das Abheben einen nicht zu großen Kraftaufwand der Bedienungsperson erfordern soll. Außerdem kann diese Anordnung nicht für solche Einrichtungen verwendet werden, die eine Mehrzahl von Behandlungsstationen aufweisen, wobei jede Behandlungsstation als eine bauliche Einheit ausgebildet ist, die mit weiteren baulichen, Einheiten zu der gesamten Einrichtung zusammengesetzt werden kann.

Der vorliegenden Erfindung liegt daher die Aufgabe zugrunde, eine Einrichtung zum Entwickeln von Druckplatten mit paarweise horizontal angeordneten Walzen der eingangs genannten Gattung zu schaffen, die einfach und bequem in der Weise zuverlässig bedienbar ist, daß zwangsweise sämtliche oberen Walzen abgehoben werden. Der hierzu erforderliche Aufwand soll möglichst gering sein. Ferner soll sich diese Einrichtung in einer Ausführungsform auch für solche Anwendungsfälle eignen, in denen die Einrichtung aus mehreren Einheiten zusammengesetzt ist, die jeweils eine Verarbeitungsstation verkörpern.

Die Erfindung geht aus von einer Einrichtung zum Entwickeln von Druckplatten mit paarweise horizontal angeordneten oberen und unteren Walzen zum Transport der Druckplatten und gegebenenfalls zum Abquetschen von an den Druckplatten haftender Restflüssigkeit, mit je einem an jedem Ende jeder oberen Walze bezüglich der unteren Walze anhebbar und absenkbar angeordneten Lager, das über eine Kniehebelanordnung betätigbar ist.

Die erfindungsgemäße Einrichtung ist dadurch gekennzeichnet, daß zum Angriff an den Lagern der oberen Walzen je ein schwenkbarer Gabelkopf mit einem oberen und einem unteren Arm vorgesehen ist, dessen Schwenkachse parallel zur Druckplattentransportrichtung gerichtet ist, dessen oberer Arm durch die Kniehebelanordnung im abgesenkten Zustand des Lagers von oben auf das Lager drückt und dessen unterer Arm das Lager im angehobenen Zustand stützt, daß ein erstes Ende jeder Kniehebelanordnung mit dem Gabelkopf in Verbindung steht und daß ein zweites Ende jeder Kniehebelanordnung mit einer allen Kniehebelanordnungen gemeinsamen drehbaren Schaltwelle in Verbindung steht, die ebenfalls parallel zur Druckplattentransportrichtung gelagert ist.

Bei dieser Einrichtung sind die Schwenkachsen der schwenkbaren Gabelköpfe parallel zur Druckplattentransportrichtung gerichtet, d.h. rechtwinkelig zu der Hauptachse der Walzen. Die an die Gabelköpfe angreifenden Kniehebelanordnungen liegen jeweils in einer Ebene, durch die die Hauptachse der abzuhebenden Walze verläuft, und führen zu der Schaltwelle, die ebenfalls parallel zur Druckplattentransportrichtung gelagert ist. An der Schaltwelle sind also alle Kniehebelanordnungen auf einer Seite sämtlicher abzuhebender Walzen angebracht, so daß die Lager dieser Walzen auf einer Seite durch eine einzige Drehbewegung der Schalt-welle angehoben werden können. Ent-sprechendes gilt für die Betätigung der Lager auf der gegenüberliegenden Seite der Walzen. Somit ist es zum Anheben sämtlicher oberen Walzen der Einrichtung nur erforderlich, daß beide Schaltwellen gedreht werden. Die Bedienung zum Anheben und Absenken der Walzen ist dadurch äußerst vereinfacht, und es ist unmöglich, eines der Lager auf einer der Seiten der Walzen versehentlich nicht anzuheben. — Ferner zeichnet sich die erfindungsgemäße Einrichtung dadurch aus, daß die Lager der Walzen nicht fest mit den Gabelköpfen oder entsprechenden Teilen verbunden sind, sondern daß die Gabelköpfe derart an den Lagern mit je einem oberen und unteren Arm angreifen, daß die oberen Walzen im angehobenen Zustand leicht aus der Einrichtung entnommen und wieder eingeführt werden können. Diese sich beim Anheben der Lager selbst lösende Befestigung der Lager ermöglicht eine einfache Wartung und erforderlichenfalls Reparatur der Einrichtung, indem die unteren Walzen nach Entnahme der oberen Walzen besonders leicht zugänglich sind.

In einer Weiterbildung der Einrichtung zum Entwickeln von Druckplatten mit einer Mehrzahl von Behandlungsstationen, wobei jede Behandlungsstation als eine bauliche Einheit ausgebildet ist, die mit weiteren baulichen Einheiten zusammensetzbar ist, ist in vorteilhafter Weise vorgesehen, daß in jeder baulichen Ein-heit ein Abschnitt der Schaltwelle gelagert ist, der mit einem Abschnitt der Schaltwelle der benachbarten baulichen Einheit über ein Kreuzkupplungsstück kuppelbar ist.

Hierin ist also jeder auch als Modul bezeichenbaren Einheit der Einrichtung, die mit weiteren Einheiten kombinierbar ist, ein Abschnitt der Schaltwelle mit einem Kreuzkupplungsstück fest zugeordnet, so daß sich beim Zusammensetzen der Einheiten eine durchgehende Schaltwelle ergibt.

Dabei wird trotz teilbarem und beliebig gruppierbarem Aufbau der Einrichtung aus mehreren Einheiten die zentrale Betätigung aller auf einer Seite liegenden Lager der oberen Walzen aufrecht erhalten.

Zur einfachen zentralen Betätigung ist ferner vorgesehen, daß an einem Ende der Schaltwelle ein Schalthebel gelagert ist, der mit der Schaltwelle in drehfester Verbindung steht.

In einer vorteilhaften Ausgestaltung der Einrichtung weist diese das weitere Merkmal auf, daß mit der Schaltwelle eine Einrastplatte verbunden ist, an die ein Druckstück mit einer federgelagerten Kugel angedrückt ist.

Mit diesem Druckstück, das zweckmäßig mit einem Teil des Schalthebels einstückig ausgebildet ist, wird erreicht daß die Schaltwelle in zwei definierte Schaltstellungen gebracht werden kann, nämlich in eine erste Stellung, in der die oberen Walzen auf die unteren Walzen gedrücktwerden und in eine zweite Stellung, in der die oberen Walzen von den unteren Walzen abgehoben werden können. In der letztgenannten Stellung kann das an der Einrastplatte anliegende Druckstück außerdem dafür sorgen, daß die Walzen in ihrer oberen Lage festgehalten werden.

Weitere vorteilhafte Merkmale der Einrichtung bestehen darin, daß der Gabelkopf mit seinem oberen und unteren Arm in einer vertikalen Ebene angeordnet ist, in der die Mittelachse der zugeordneten Walze leigt und daß ein Führungslager mit zwei Seitenarmen in einer horizontalen Ebene, in der ebenfalls die Mittelachse der Walze liegt, derart ortsfest angebracht ist, daß die Seitenarme das ihnen gegenüber vertikal verschiebbare Lager umgreifen.

Bei dieser Anordnung wird also jedes Lager auf mindestens drei Seiten gehalten, nämlich auf zwei in Druckplattentransportrichtung liegenden Seiten und — im angehobenen Zustand — von unten bzw. — im abgesenkten Zustand — von oben. Diese Anordnung ist dabei in vorteilhafter Weise so getroffen, daß die Walzen in der angehobenen Stellung des Gebalkopfes herausgehoben werden können und wieder zwischen die beiden Seitenarme des Führungslagers eingesetzt werden können.

Zur Entnahme der Walzen ist ferner in vorteilhafter Weise vorgesehen daß der obere Arm des Gabelkopfes so lang bemessen ist, daß er im angehobenen Zustand des Lagers das Lager nach oben hin freigibt.

Der obere Arm des Gabelkopfes drückt also nur dann auf das lager, wenn die obere Walze auf die untere Walze gepreßt werden soll.

Zweckmäßig ist die Einrichtung so ausgestaltet, daß an dem oberen Arm eine Andruckrolle drehbar gelagert ist und daß an dem unteren Arm eine Anheberolle drehbar gelagert ist.

Mit dieser Andruckrolle und Anheberolle werden die Bedienungskräfte beim Anheben der oberen Walzen bzw. beim Anpressen der oberen Walzen auf die unteren Walzen wesentlich herabgesetzt. Diese Anordnung mit Andruckrolle und Anheberolle ist außerdem verschleißarm, so daß sich insofern eine Nachstellung oder gar ein Austausch von Teilen über einen langen Zeitraum erübrigt.

In einer besonders vorteilhaften Weiterbildung der Einrichtung ist vorgesehen, daß die Kniehebelanordnung einen mit der Schaltwelle drehfest verbindbaren Kniegelenkhebel aufweist, der über ein Kniegelenklager mit einer ersten Gewindestange verbunden ist, daß die erste Gewindestange über eine Spannschloßmutter mit einer zweiten Gewindestange verbunden ist, an deren Ende der Gabelkopf schwenkbar gelagert ist, und daß die erste Gewindestange mit einem Rechtsgewinde in der Spannschloßmutter verdrehbar ist und die zweite Gewindestange mit einem Linksgewinde ebenfalls in der Spannschloßmutter verdrehbar ist.

Bei dieser Anordnung kann durch Verdrehen der Spannschloßmutter der Andruck der oberen Walzen auf die unteren Walzen eingestellt werden, und es kann die Höhe der Abhebung der oberen Walzen von den unteren Walzen einreguliert werden.

Schließlich ist eine solche Ausgestaltung der Einrichtung vorteilhaft, daß an jedem Lager ein Stützring vorgesehen ist, der ein auf dem Wellenstummel der Walze sitzendes Kugellager umfaßt.

Durch diesen Stützring können die von den Armen des Gabelkopfes und von den Seitenarmen des Führungslagers herrührenden Kräfte gleichmäßig auf den äußeren Ring des Kugellagers verteilt werden. Außerdem ist durch den Stützring eine Anpassung unterschiedlicher Kugellagerdurchmesser an die Dimensionierung des Gabelkopfes und des Führungslagers möglich.

Die Erfindung wird im folgenden anhand einer Zeichnung mit 14 Figuren näher erläutert.

Es zeigt:

Fig. 1 einen wesentlichen Teil der aus mehreren baulichen Einheiten bestehenden Einrichtung zum Entwickeln von Druckplatten in einer Draufsicht,

Fig. 2 eine mit einer Schaltwelle verbundene Kniehebelanordnung im abgesenkten Zustand in einer Ansicht von vorne,

Fig. 3 die Anordnung nach Fig. 2, jedoch in angehobenem Zustand,

Fig. 4 die Kniehebelanordnung mit Führungslager im abgesenkten Zustand in einer gegenüber Fig. 2 größeren Darstellung von vorn,

Fig. 5 die Kniehebelanordnung nach Fig. 4, jedoch im angehobenen Zustand,

Fig. 6 eine Einzelheit aus Fig. 4 in einer Ansicht von unten in Richtung des Pfeils A in Fig. 4,

Fig. 7 eine Einzelheit aus Fig. 4, nämlich den herabgeschwenkten Gabelkopf, der über ein Lager eine obere Walze auf eine untere Walze drückt,

Fig. 8 die Anordnung nach Fig. 7, jedoch im angehobenen Zustand des Lagers und der zugehörigen oberen Walze,

Fig. 9 einen Querschnitt entlang der Linie AB in Fig. 7,

Fig. 10 einen Querschnitt entlang der Linie AB in Fig. 8,

Fig. 11 ein Kreuzkupplungsstück zur Kupplung zweier Abschnitte der Schaltwelle,

Fig. 12 einen Querschnitt durch das Kreuzkupplungsstück entlang der Linie AB in Fig. 11,

Fig. 13 einen Querschnitt durch das Kreuzkupplungsstück entlang der Linie CD in Fig. 11 und

Fig. 14 einen Schalthebel samt Einrastplatte und Lagerung in einer Seitenansicht, teilweise geschnitten.

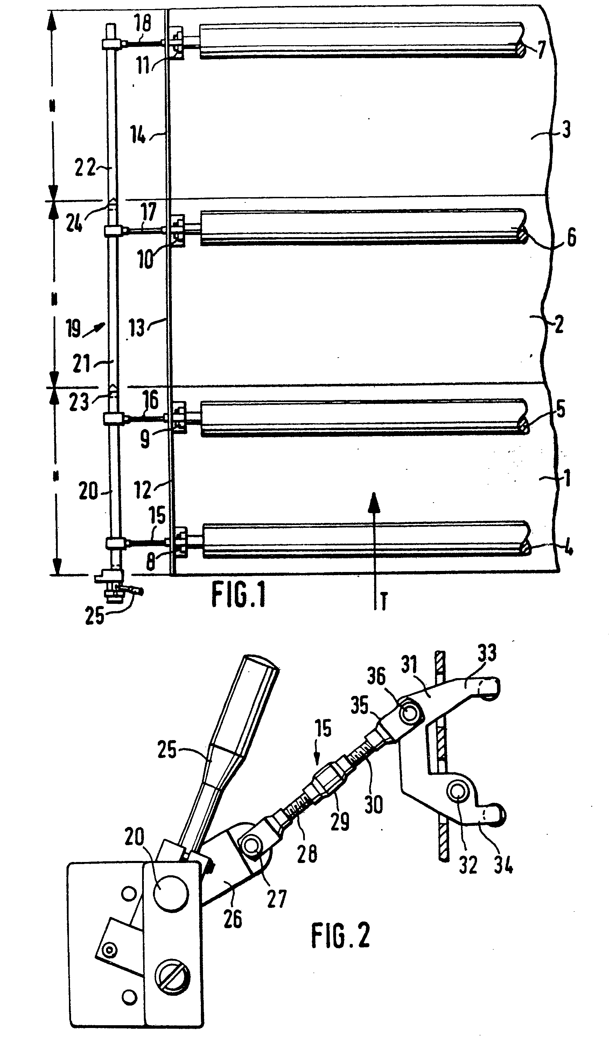

In Fig. 1 sind mit 1, 2, 3 drei bauliche Einheiten bezeichnet, die je eine Kopierstation verkörpern. Es sind in Transportrichtung T gesehen eine Entwicklungsstation, eine Wässerungsstation und eine Station zum Aufbringen einer Schutzschicht auf die entwickelte und gewässerte Druckplatte. Aus Fig. 1 sind nicht die eigentlichen Bearbeitungsorgane ersichtlich, die aus Sprührohren, Rakeln und Bürstenwalzen bestehen können, wohl aber Walzenpaare, die zum Transport der Druckplatten durch die Einrichtung und gegenbenenfalls zum Abquetschen von Restflüssigkeit von den Druckplatten dienen. Im einzelnen sind von diesen Walzenpaaren die oberen Walzen 4, 5 in der ersten baulichen Einheit erkennbar, sowie die oberen Walzen 6 und 7 in den baulichen Einheiten 2 bzw. 3. Die Walzen 4 bis 7 sind auf ihrer linken Seite mit je einem Lager 8 bis 11 gelagert, das in noch zu beschreibender Weise in je einer Seitenplatine 12, 13, 14 jeder baulichen Einheit gehalten wird.

Jedes der Lager 8 bis 11 ist über eine Kniehebelanordnung 15 bis 18 mit einer Schaltwelle 19 gekuppelt, die parallel zur Transportrichtung T an der Einrichtung gelagert ist.

Im einzelnen besteht die Schaltwelle aus drei Abschnitten 20, 21, 22, die je einer baulichen Einheit zugeordnet sind und über je ein Kreuzkupplungsstück 23 bzw. 24 miteinander drehfest verbunden sind. Zur Betätigung der Schaltwelle ist an ihrem vorderen Abschnitt ein Schalthebel 25 als Betätigungsorgan angebracht.

In Fig. 1 ist von der Einrichtung zum Entwickeln von Druckplatten nur ein linker Abschnitt dargestellt, an dem sich rechts ein in gleicher Weise aufgebauter rechter Abschnitt anschleißt.

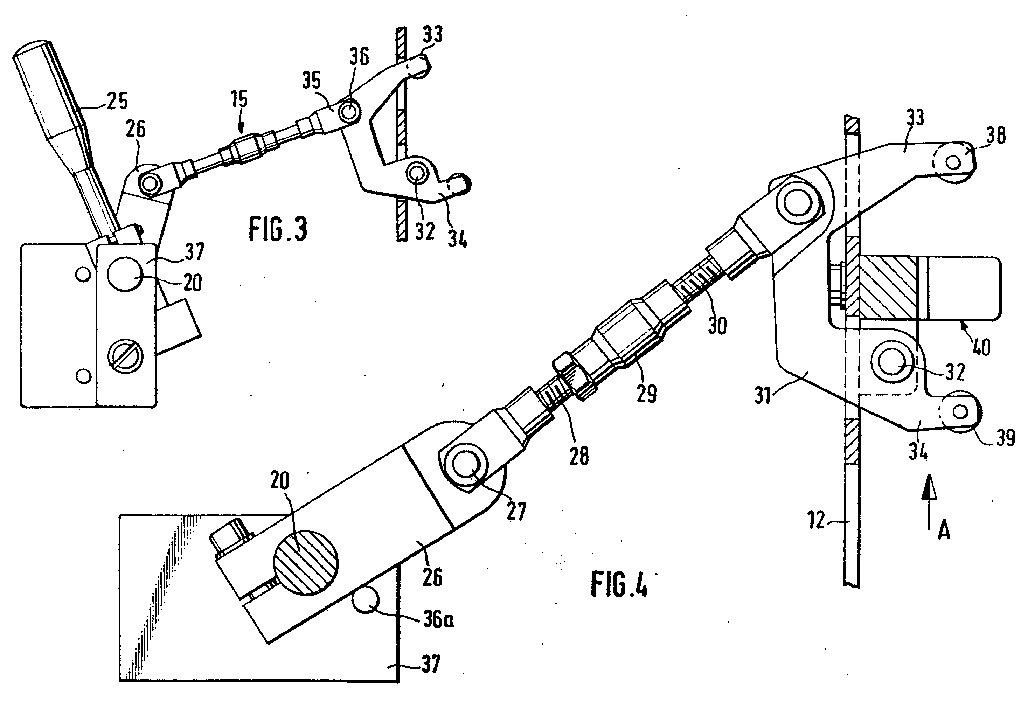

In den Figuren 2 und 3 ist die Kniehebelanordnung 15 in Verbindung mit dem Abschnitt 20 der Schaltwelle sowie mit dem Schalthebel 25 in zwei Schaltstellungen dargestellt:

In der Schaltstellung zum Absenken der oberen Walze auf eine untere Walze nach Fig. 2 ist der Schalthebel 25 nach rechts geschwenkt, wodurch ein mit der Schaltwelle drehfest verbundener Kniegelenkhebel 26 ebenfalls nach rechts geschwenkt ist. Der Kniegelenkhebel steht über ein Kniegelenklager 27, über eine erste Gewindestange 28, über eine Spannschloßmutter 29 und über eine zweite Gewindestange 30 mit einem Gabelkopf 31 in Verbindung, der um eine ebenfalls parallel zur Druckplattentransportrichtung verlaufende Schwenkachse 32 schwenkbar ist.

In der Fig. 2 befindet sich die Kniehebelanordnung 15 in einer solchen Stellung, daß ein oberer Arm 33 des Gabelkopfes das nicht dargestellte Lager, das er zusammen mit einem unteren Arm 34 einschließt, derart herabdrückt, daß die obere Walze auf die zugehörige Walze mit dem gewünschten Anpreßdruck gepreßt wird. In der in Fig. 3 dargestellten Position wird dagegen das nicht dargestellte Lager der oberen Walze durch den unteren Arm 34 des Gabelkopfes angehoben, so daß die obere Walze von der unteren Walze abhebt. Diese Einstellung erfolgt durch eine Verschwenkung des Schalthebels 25 nach links, durch die der Kniegelenkhebel 26 ebenfalls nach links geschwenkt wird. In dieser Position ist der Gabelkopf um die Schwenkachse 32 entgegen dem Uhrzeigersinn zurückgeschwenkt, wobei zugleich der obere Arm 33 soweit zurücktritt, daß das nicht dargestellte Lager zum Abheben nach oben zusammen mit der oberen Walze freigegeben wird.

Im Zusammenhang mit den Figuren 2 bis 4 wird bemerkt, daß die Kniehebelanordnung 15 insgesamt aus dem Kniegelenkhebel 26, dem Kniegelenklager 27, der ersten Gewindestange 28, der Spannschloßmutter 29 und der zweiten Gewindestange 30 besteht. Das erste Ende der Kniehebelanordnung 35 greift dabei an ein Lager 36 des Gabelkopfes an, während der Kniehebel 26 an einem Anschlagstift 36a anliegt, der in ein Lager 37 der Schaltwelle eingelassen ist.

In Fig. 4 ist der an den Abschnitt 20 der Schaltwelle geklemmte Kniegelenkhebel 26 nach rechts geschwenkt, damit der Gabelkopf in die zum Andrücken der oberen Walze auf die untere Walze enforderliche Lage geschwenkt ist.

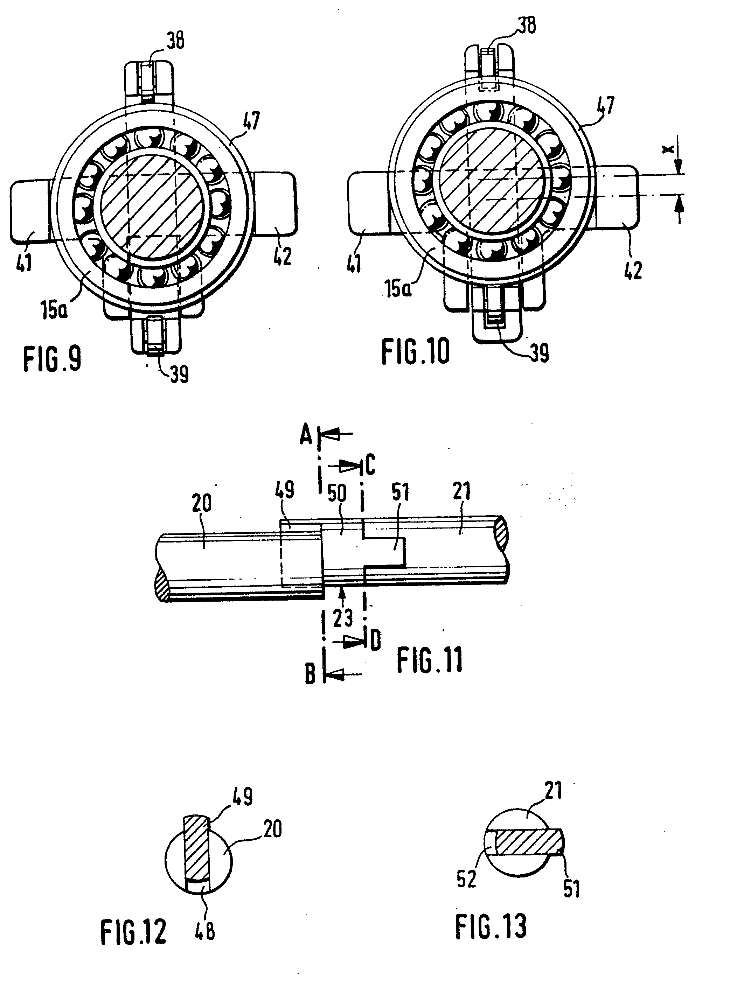

Aus Fig. 4 ist ferner ersichtlich, daß an dem oberen Arm 33 des Gabelkopfes eine Andruckrolle 38 gelagert ist, während an dem unteren Arm 34 eine Anheberolle 39 gelagert ist. Schließlich kann aus Fig. 4 entnommen werden, wie ein Führungslager 40 an der Platine 12 befestigt ist, so daß das nicht dargestellte Lager der oberen Walze von zwei Seitenarmen 41 und 42 des Führungslagers, vgl. Fig. 9, eingeschlossen wird. In einen unteren Abschnitt des Führungslagers ist die Schwenkachse 32 eingelassen.

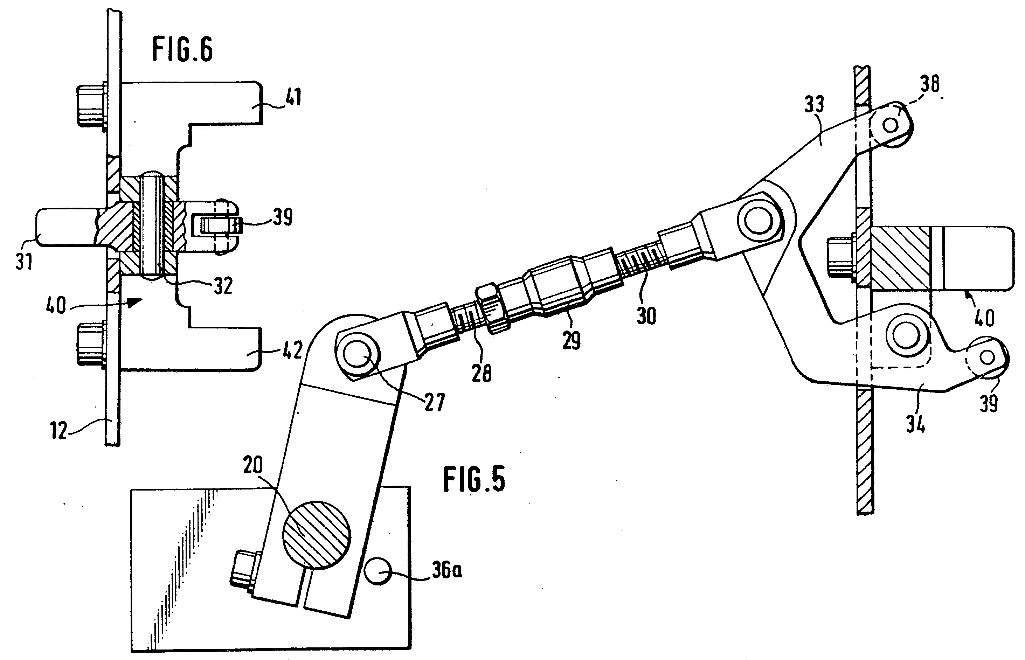

In Fig. 5 befindet sich die Kniehebelanordnung in der Schaltstellung zum Entlasten der Walzen, wobei durch die Anheberolle 39 das nicht dargestellte Lager der oberen Walze angehoben wird. Dabei wird das obere Lager zwischen den Seitenarmen 41, 42 des Führungslagers geführt, vgl. Fig. 10.

Durch Verdrehen der Spannschloßmutter 29 gegenüber der ersten und zweiten Gewindestange 28 und 30 läßt sich der Andruck der Walzen im abgesenkten Zustand des oberen Arms 33 bzw. die Höhe der Anhebung der oberen Walze durch den unteren Arm 34 einstellen.

Aus Fig. 6, in der das Führungslager 40 mit seinen Seitenarmen 41 und 42 in einer Ansicht von unten dargestellt ist, läßt sich besonders gut die aufgebrochen gezeichnete Lagerung des Gabelkopfes 31 um die Schwenkachse 32 erkennen. Der Gabelkopf und das Führungslager bilden also eine Einheit, die mit der Seitenplatine 12 verbindbar ist.

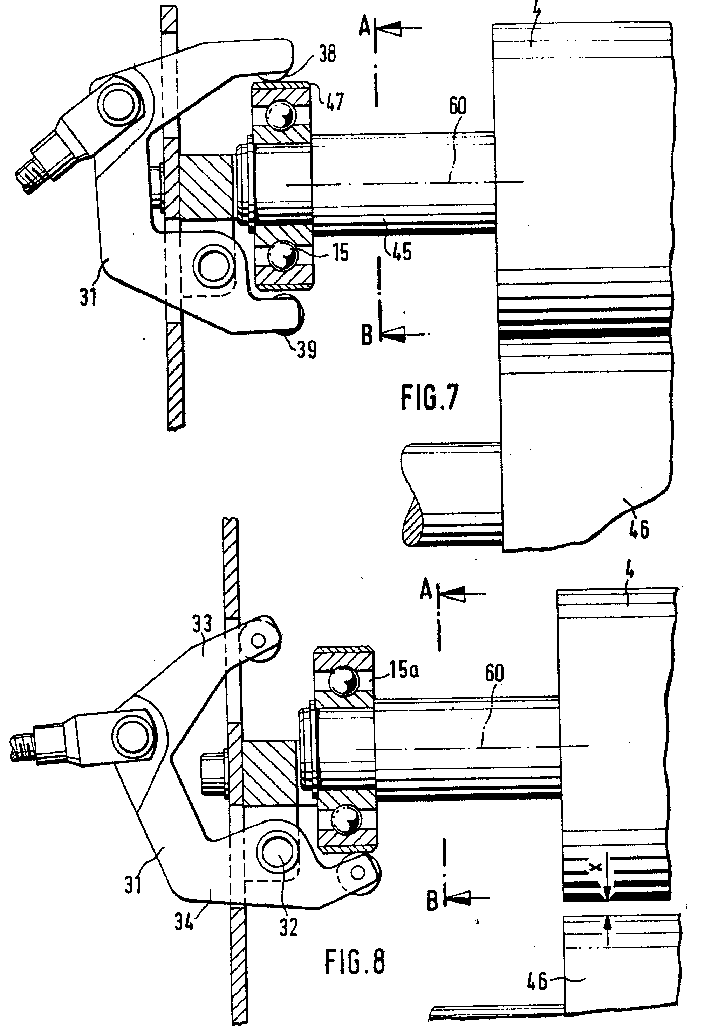

Aus Fig. 7 kann man erkennen, wie die Gabelkopf 31 das auf dem Wellenstummel 45 sitzende Lager herabdrückt, so daß die obere Walze 4 auf die zugehörige untere Walze 46 gepreßt wird. Diese Schaltstellung ist in Fig. 9 in einer Sicht auf den Querschnitt entsprechend der Schnittlinie AB in Fig. 7 dargestellt. Aus diesen beiden Figuren läßt sich auch entnehmen, daß das eigentliche Lager 15a in einen Stützring 47 eingefaßt ist. An diesem Stützring können die obere Andruckrolle 38 und die untere Anheberolle 39 abrollen.

In Fig. 8 befindet sich der Gabelkopf 31 in seiner Stellung zum Entlasten der Walzen 4 und 46 eines Walzenpaares, wobei die obere Walze 4 um den Betrag x angehoben wird. — Die anhebbaren Teile der Einrichtung in dieser Schaltlage sind aus einer Sicht auf den Schnitt entlang der Linie AB in Fig. 10 dargestellt.

Aus Fig. 8 ist schließlich noch ersichtlich, daß der obere Arm 33 in der angehobenen Stellung der oberen Walze 4 soweit zurücktritt, daß die obere Walze 4 mit ihrem Lager 15a frei nach oben abgehoben werden kann.

In den Fig. 11 bis 13 ist ein Kreuzkupplungsstück 23 zum Kuppeln der Abschnitte 20 und 21 der Schaltwelle in seinen Einzelheiten zu sehen. Danach ist aus der Stirnseite der Schaltwelle 20 eine Nut 48 ausgespart, in die ein Gleitfinger 49 eines Zwischenstücks 50 hineinreicht. Das Zwischenstück ist mit einem Finger 51 in eine Nut 52 des Abschnitts 21 der Schaltwelle eingeführt.

Dadurch wird eine in Drehrichtung kraft- und formschlüssige Verbindung der Abschnitte der Schaltwelle hergestellt, wobei durch das Zwischenstück 50 Fluchtungsfehler der Abschnitte ausgeglichen werden.

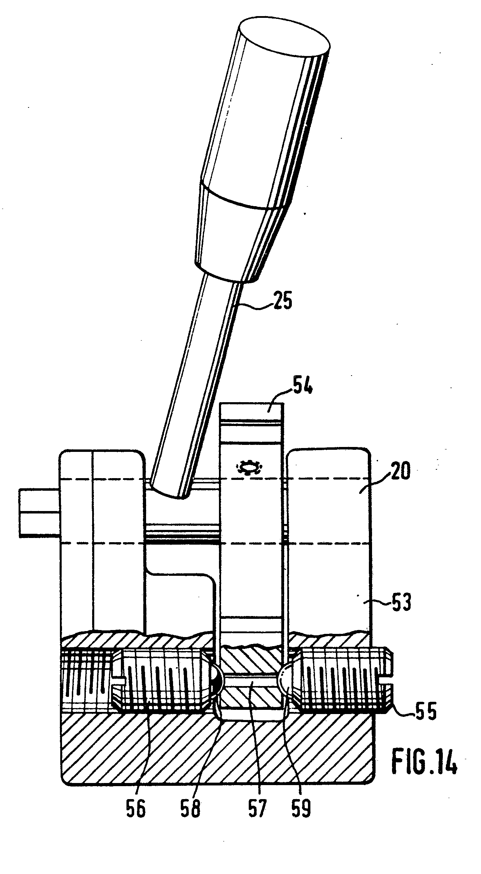

In Fig. 14 ist dargestellt, wie der Schalthebel 25 in den Abschnitt 20 der Schaltwelle eingelassen ist, die wiederum in einem Lager 53 für den Schalthebel gelagert ist. Mit dem Abschnitt 20 ist ferner eine Einrastplatte 54 drehfest verbunden, die mit zwei Druckstücken 55 und 56 zusammenwirkt. Die Druckstücke dienen zur Fixierung der Schaltwelle in der Stellung, in der die Schaltwelle zum Anheben der oberen Walzen verdreht ist. Die Druckstücke umfassen jeweils eine in eine Bohrung 57 der Einrastplatte gedrückte Kugel 58 bzw. 59, die jeweils unter der Kraft einer in jedem Druckstück untergebrachten Druckfeder steht.

**Patentansprüche**

1. Einrichtung zum Entwickeln von Druckplatten mit paarweise horizontal angeordneten oberen und unteren Walzen zum Transport der Druckplatten und gegebenenfalls zum Abquetschen von an den Druckplatten haftender Restflüssigkeit, mit je einem an jedem Ende jeder oberen Walze bezüglich der unteren Walze anhebbar und absenkbar angeordneten Lager, das über eine Kniehebelanordnung betätigbar ist, dadurch gekennzeichnet, daß zum Angriff an den Lagern (8 bis 11) der oberen Walzen (4 bis 7) je ein schwenkbarer Gabelkopf (z.B. 31) mit einem oberen und einem unteren Arm (33, 34) vorgesehen ist, dessen Schwenkachse (32) parallel zur Druckplattentransportrichtung (T) gerichtet ist, dessen oberer Arm (33) durch die Kniehebelanordnung (26—30) im abgesenkten Zustand des Lagers (15) von oben auf das Lager drückt und dessen unterer Arm (34) das Lager im abgehobenen Zustand stützt, daß ein erstes Ende jeder Kniehebelanordnung mit dem Gabelkopf (z.B. 31) in Verbindung steht und daß ein zweites Ende jeder Kniehebelanordnung mit einer allen Kniehebelanordnungen gemeinsamen drehbaren Schaltwelle (19) in Verbindung steht, die ebenfalls parallel zur Druckplattentransportrichtung (T) gelagert ist.

2. Einrichtung nach Anspruch 1, dadurch gekennzeichnet dass sie mehrere Behandlungsstationen hat, wobei jede als eine bauliche Einheit 1) ausgebildet ist, die mit weiteren baulichen Einheiten (2, 3) zusammensetzbar ist, und in jeder solchen Einheit ein Abschnitt (20 bzw. 21 bzw. 22) der Schaltwelle gelagert ist, der mit einem Abschnitt der Schaltwelle der benachbarten baulichen Einheit über ein Kreuzkupplungsstück (23, 24) kuppelbar ist.

3. Einrichtung nach Anspruch 1 oder 2, dadurch gekennzeichnet, daß an einem Ende der Schaltwelle ein Schalthebel (25) gelagert ist, der mit der Schaltwelle in drehfester Verbindung steht.

4. Einrichtung nach einem der Ansprüche 1 bis 3, dadurch gekennzeichnet, daß mit der Schaltwelle (19) eine Einrastplatte (54) verbunden ist, an die ein Druckstück (55, 56) mit einer federgelagerten Kugel (58, 59) angedrückt ist.

5. Einrichtung nach einem der vorangehenden Ansprüche, dadurch gekennzeichnet, daß der Gabelkopf (z.B. 31) mit seinem oberen Arm (33) und unteren Arm (34) in einer vertikalen Ebene angeordnet ist, in der die Mittelachse der zugeordneten Walze liegt, und daß ein Führungslager (40) mit zwei Seitenarmen (41, 42) in einer horizontalen Ebene, in der ebenfalls die Mittelachse (60) der Walze liegt, derart ortsfest angebracht ist, daß die Seitenarme (41, 42) das ihnen gegenüber vertikal verschiebbare Lager umgreifen.

6. Einrichtung nach Anspruch 1 oder 5, dadurch gekennzeichnet, daß der obere Arm (33) des Gabelkopfs (31) so lang bemessen ist, daß er im angehobenen Zustand des Lagers das Lager (15) nach oben hin freigibt.

7. Einrichtung nach einem der Ansprüche 1, 5 oder 6, dadurch gekennzeichnet, daß an dem oberen Arm (33) eine Andruckrolle (38) drehbar gelagert ist und daß an dem unteren Arm (34) eine Abheberolle (39) drehbar gelagert ist.

8. Einrichtung nach einem der vorangehenden Ansprüche, dadurch gekennzeichnet, daß die Kniehebelanordnung (26—30) einen mit der Schaltwelle (19) drehfest verbindbaren Kniegelenkhebel (26) aufweist, der über ein Kniegelenklager (27) mit einer ersten Gewindestange (28) verbunden ist, daß die erste Gewindestange über eine Spannschloßmutter (29) mit einer zweiten Gewindestange (30) verbunden ist, an deren Ende der Gabelkopf (31) schwenkbar gelagert ist, daß die erste Gewindestange (28) mit einem Rechtsgewinde in der Spannschloßmutter verdrehbar ist und daß die zweite Gewindestange (30) mit einem Linksgewinde ebenfalls in der Spannschloßmutter verdrehbar ist.

9. Einrichtung nach einem der vorangehenden Ansprüche, dadurch gekennzeichnet, daß an jedem Lager ein Stützring (47) vorgesehen ist, der ein auf dem Wellenstummel der Walze sitzendes Kugellager umfaßt.

**Claims**

1. An apparatus for developing printing plates, comprising upper and lower rolls arranged in pairs in a horizontal position, which serve to convey the printing plates and, if appropriate, to squeeze off any residual liquid adhering to the printing plates, further comprising a bearing each disposed at each end of each upper roll, which may be raised and lowered with respect to the lower roll and which may be actuated by way of a toggle lever arrangement, characterised in that a pivoted forked head each (e.g. 31) having an upper and a lower arm (33, 34) is provided for engaging the bearings (8 to 11) of the upper rolls (4 to 7), with the swivel shaft (32) of the forked head extending in parallel with the direction of transport (T) of the printing plates and the upper arm (33) of the forked head exerting pressure from above upon the bearing (15) by means of the toggle lever arrangement (26 to 30) when the bearing is in the lowered position, and the lower arm (34) of the forked head supporting the bearing when the latter is in the raised position, further that a first end of each toggle lever arrangement is connected with the forked head (e.g. 31) and that a second end of each toggle lever arrangement is connected with a rotatable control shaft (19) which is common to all toggle lever arrangements and which is also supported in parallel with the direction of transport (T) of the printing plates.

2. An apparatus according to claim 1, characterised in that it comprises a plurality of processing stations, each station being designed as a structural unit (1) which may be assembled with further structural units (2, 3), and that each of said units includes a section (20 or 21 or 22) of the control shaft which may be coupled with a section of the control shaft in the neighbouring structural unit by way of a cross coupling piece (23, 24).

3. An apparatus according to claim 1 or claim 2, characterised in that a control lever (25) is disposed at one end of the control shaft and is rigidly connected with the control shaft.

4. An apparatus according to any one of claims 1 to 3, characterised in that a locking plate (54) is connected with the control shaft (19) and that a thrust piece (55, 56) comprising a spring-mounted ball (58, 59) is pressed against the locking plate.

5. An apparatus according to any one of the preceding claims, characterised in that the forked head (e.g. 31) is with its upper arm (33) and its lower arm (34) arranged in a vertical plane in which the axis of the appertaining roll lies, and in that a guide bearing (40) having two lateral arms (41, 42) is stationarily fastened in a horizontal plane in which the axis (60) of the roll also lies, in such a manner that the lateral arms (41, 42) encompass the bearing which is vertically displaceable with respect to the lateral arms.

6. An apparatus according to claim 1 or claim 5, characterised in that the upper arm (33) of the forked head (31) is dimensioned such that it clears the bearing (15) in upward direction when the latter is in the raised position.

7. An apparatus according to any one of claims 1, 5 or 6, characterised in that a pressure roller (38) is rotatably mounted on the upper arm (33) and that a lifting roller (39) is rotatably mounted on the lower arm (34) of the forked head.

8. An apparatus according to any one of the preceding claims, characterised in that the toggle lever arrangement (26 to 30) comprises a toggle lever (26) which may be rigidly connected with the control shaft (19) and is linked with a first threaded rod (28) via a toggle joint bearing (27), that the first threaded rod is, via a turnbuckle nut (29) connected with a second threaded rod (30) at the end of which the forked head (31) is pivoted, that the first threaded rod (28) may be adjusted in the turnbuckle nut by means of a right-hand thread, and the second threaded rod (30) may also be adjusted in the turnbuckle nut by means of a left-hand thread.

9. An apparatus according to any one of the preceding claims, characterised in that, at each bearing, a support ring (47) is provided which encloses a ball bearing mounted on the shaft journal of the roll.

**Revendications**

1. Dispositif pour le développement de plaques à imprimer comportant, des rouleaux horizontaux supérieurs et inférieurs, disposés par paires et assurant le transport de ces plaques à imprimer, et, le cas échéant, l'élimination par écrasement du liquide résiduel adhérant à celles-ci, et, des roulements qui équipent chacune des extrémités de chacun des rouleaux supérieurs, et qui peuvent être levés et abaissés par rapport au rouleau inférieur, et qui sont commandés par des leviers articulés, ce dispositif étant caractérisé en ce que l'engrènement de chacun des roulements (8 à 11) des rouleaux supérieurs (4 à 7) est assuré par une fourche articulée orientable (par example fourche 31) qui comporte un bras supérieur (33) et un bras inférieur (34), et dont l'axe de pivotement (32) s'étend parallèlement au sens du transport (T) des plaques à imprimer, à la suite de quoi, et en position abaissée du roulement (15), le bras supérieur (33) agit, par l'intermédiaire du levier articulé (26 à 30), sur ce roulement abaissé (15) en s'y appuyant du haut en bas, tandis qu'en position décollée du roulement, le bras inférieur (34) de la fourche assure le support de ce même roulement, et en ce qu'une première extrémité de chacun des leviers articulés est reliée à la fourche (31, par example), et en ce que la deuxième extrémité de chacun de ces leviers articulés est reliée à un arbre de commande (19), rotatif commun à tous les leviers articulés, et dirigé parallèlement au sens du transport (T) des plaques à imprimer.

2. Dispositif selon la revendication 1, caractérisé en ce qu'il comporte plusieurs stations de traitement, dont chacune constitue une unité de construction (1) pouvant être associée avec d'autres unités de construction (2, 3), et en ce que chaque unité est desservie par une partie déterminée de l'arbre de commande (20, 21, 22) qui, par l'intermédiaire d'un crosillon (23, 24), peut être raccordée à la partie de l'arbre de commande desservant l'unité voisine.

3. Dispositif selon l'une des revendications 1 ou 2, caractérisé en ce que l'une des extrémités de l'arbre de commande porte un levier de commande (25), maintenu fixement sure cet arbre.

4. Dispositif selon l'une quelconque des revendications 1 à 3, caractérisé en ce que l'arbre de commande (19) est relié à une plaque d'encliquetage (54) contre laquelle s'appuie un élément de serrage (55, 56), équipé d'une bille (58, 59) montée sur ressort.

5. Dispositif selon l'une quelconque des revendications indiquées ci-dessus, caractérisé en ce que le bras supérieur (33) et le bras inférieur (34) de la tête en forme de fourche (31, par example) se trouvent dans le même plan vertical que l'axe central du rouleau correspondant, et en ce qu'un palier-guide (40), doté de deux ailes latérales (41, 42) se trouve immobilisé dans le même plan horizontal que l'axe central (60) du rouleau, de manière que ses ailes latérales (41, 42) embrassent le roulement coulissant dans le sens vertical par rapport à ces ailes.

6. Dispositif selon l'une quelconque des revendications 1 ou 5, caractérisé en ce que la longeur du bras supérieur (33) de la tête en forme de fourche (31) est déterminée de manière qu'en position relevée du roulement (15), celui-ci se trouve libéré vers le haut.

7. Dispositif selon l'une quelconque des revendications 1, 5 ou 6, caractérisé en ce que le bras supérieur (33) porte un galet d'appui (38) monté en roulement libre, et en ce que le bras inférieur (34) porte un galet de décollage (39) également monté en roulement libre.

8. Dispositif selon l'une quelconque des revendications indiquées ci-dessus, caractérisé en ce que le levier articulé (26 à 30) comporte un levier à genouillère (26) qui, peut être fixement relié à l'arbre de commande (19), et qui, par l'intermédiaire d'un axe de pivotement (27), est relié a une première tige filetée (28), en ce que cette première tige filetée est reliée, par l'intermédiaire d'un écrou de serrage (29), à une deuxième tige filetée (30), sur l'extrémité de laquelle s'articule la tête en forme de fourche (31), et en ce que la première tige (28) filetée, peut être ajustée dans l'écrou de serrage, par un pas de vis à droite, alors que la deuxième tige filetée (30) peut être ajustée dans ce même écrou de serrage par un pas de vis à gauche.

9. Dispositif selon l'une quelconque des revendications indiquées ci-dessus, caractérisé en ce que chaque roulement porte une bague d'appui (47) qui enrobe le roulement à billes monté sur l'extrémité du rouleau.

FIG.1

FIG.2

FIG.3

FIG.4

**FIG.5**

**FIG.6**

**FIG.7**

**FIG.8**

4

FIG.9

FIG.10

FIG.11

FIG.12

FIG.13

FIG.14